# EUROPÄISCHE PATENTSCHRIFT

(11) **EP 3 449 690 B1**
(45) Veröffentlichungstag und Bekanntmachung des Hinweises auf die Patenterteilung: **13.04.2022**
(21) Anmeldenummer: 17702793.5
(22) Anmeldetag: 24.01.2017
(51) Int. Cl.: H05B 3/84, H01R 13/66, B32B 17/10

(54) **ANORDNUNG ZUM ANSCHLUSS EINES FLÄCHENKÖRPERS AN EINE SPANNUNGSVERSORGUNG MIT EINGEBETTETER STEUEREINHEIT**
ASSEMBLY FOR CONNECTING A SURFACE BODY TO A POWER SUPPLY HAVING AN EMBEDDED CONTROL UNIT
SYSTEME DE RACCORDEMENT D'UNE NAPPE SUR UNE ALIMENTATION EN COURANT A L'AIDE D'UNE UNITE DE COMMANDE INTEGREE

(30) Priorität: 27.04.2016 EP 16167244
(43) Veröffentlichungstag der Anmeldung: 06.03.2019
(73) Patentinhaber: SAINT-GOBAIN GLASS FRANCE, 92400 Courbevoie (FR)
(72) Erfinder: WEBER, Patrick, 52477 Alsdorf (DE)
(74) Vertreter: Weber, Sophie
(86) Internationale Anmeldenummer: PCT/EP2017/051347
(87) Internationale Veröffentlichungsnummer: WO 2017/186360

(56) Entgegenhaltungen:
- EP-A1- 2 669 083
- WO-A1-2015/162107
- DE-A1-102011 121 921
- DE-C1- 10 132 963

## Beschreibung

Die Erfindung betrifft eine Anordnung zum Anschluss eines Flächenkörpers an eine Spannungsversorgung, mit einem Flachbandkabel, einer Steuereinheit und einem Anschlusselement, wobei die Spannungsversorgung zumindest zur Versorgung der Steuereinheit mit einer elektrischen Spannung vorgesehen ist und der Flächenkörper eine elektrisch leitfähige Struktur, eine Schaltfläche zur Generierung eines Steuersignals aufweist und die Steuereinheit zum Empfang des Steuersignals vorgesehen ist.

Flächenkörper, wie z.B. Fahrzeugscheiben sind mit zumindest einer elektrisch leitfähigen Struktur ausgestattet, um zusätzliche Funktionalität der Fahrzeugscheibe anzubieten. Zusätzliche Funktionalität der Fahrzeugscheibe kann eine elektrische Scheibenheizung oder eine in der Fahrzeugscheibe integrierte Regensensorik sein. In Wohnräumen sind Flächenkörper als Heizkörper an Wänden oder als beheizbare Spiegel bekannt.

Zur Steuerung der Funktionalität weist der Flächenkörper eine Schaltfläche auf, über die ein Benutzer die Funktionalität steuern kann. Diese Schaltflächen können als kapazitive Schaltflächen (Touch Control) in Form von Linien- oder Flächenelektroden ausgebildet sein. Durch eine Berührung der Schaltfläche wird ein Steuersignal generiert, das über eine elektrische Verbindung an eine Steuereinheit übertragen wird. Die Steuereinheit führt dann eine vom Steuersignal abhängige Funktion aus.

EP 2669083 A1 beschreibt einen Flächenkörper mit einer Anschlussbaugruppe, die eine elektrisch leitfähige Struktur des Flächenkörpers mit einem elektrischen Außenanschluss elektrisch verbindet. Die Anschlussbaugruppe umfasst ein Flachbandkabel mit einem Flachbandleiter, der aus einem elektrisch leitfähigen Material besteht und von einer Ummantelung aus einem elektrisch isolierenden Material umgeben ist. Der Flachbandleiter ist an einem Ende an die elektrisch leitfähige Struktur des Flächenkörpers und an seinem anderen Ende mit einem Rundleiter elektrisch verbunden.

Dieser Anschluss des Flachbandleiters an den Rundleiter bildet eine Anschlusszone, die in einen von einem Anschlussgehäuse umgebenen Dichtmassenverbund eingebettet wird. Der Rundleiter mündet in einem Anschlusselement, beispielsweise einem elektrischen Stecker.

Aus physikalischen Gründen erzeugen Flachbandleiter und Rundleiter unerwünschte parasitäre Verluste. Diese Verluste entstehen durch eine kapazitive Kopplung mit der Umgebung und werden auch als sogenannte Parasitär Kapazität bezeichnet. Die Parasitär Kapazität kann ein unerwünschtes Schaltsignal der Schaltfläche erzeugen.

DE 10 2011 121921 A1 offenbart eine Anordnung zum Beheizen einer Scheibe eines Fahrzeugs mit einer Flächenheizung, die über eine Anschlussleitung mit einem Stromnetz des Fahrzeugs verbunden ist. Weiterhin offenbart D1 eine Sensoreinheit zur Erfassung von für die Beheizung der Scheibe relevanten Daten. Dabei ist eine Feuchte-Sensoreinheit durch Klebung mit der Anschlussleitung verbunden oder bereits bei der Herstellung der Anschlussleitung in die Kunststoffmatrix derselben integriert. Die Feuchte-Sensoreinheit ist elektrisch mit einer elektronischen Heizungssteuereinheit verbunden, die wiederum ist elektrisch mit einer elektronischen Schaltereinheit zur Schaltung der Scheibenheizung verbunden.

DE 101 32 963 C1 offenbart eine Klemmvorrichtung zum Befestigen von Glasscheiben, die zwei an einer Glassscheibe ansetzbaren Klemmteile aufweist. Die Klemmteile weisen an ihren Innenseiten zwei Klemmpolster auf, die von einer Klemmschraube gegeneinander spannbar sind. Weiterhin weist die Klemmvorrichtung einen flexiblen, mechanisch nachgiebigen elektrischen Anschluss mit einer mehrpoligen Steckverbindung für mehrschichtige Glasscheiben mit einer elektrischen Leiteranordnung auf.

WO 2015/162107 A1 offenbart eine Scheibe mit beleuchteter Schaltfläche und Heizfunktion. Die Scheibe weist ein transparentes Substrat und einen Heizbereich auf, der mit zwei Sammelleitern zum Anschluss an eine Spannungsquelle verbunden ist.

Die Aufgabe der vorliegenden Erfindung besteht darin, eine verbesserte Anordnung zum Anschluss eines Flächenkörpers an eine Spannungsversorgung bereitzustellen, die eine Verringerung der parasitären Verluste aufweist.

Die Aufgabe der vorliegenden Erfindung wird erfindungsgemäß durch eine Anordnung zum Anschluss eines Flächenkörpers an eine Spannungsversorgung sowie einen Flächenkörper mit einer Anordnung gemäß dem unabhängigen Anspruch 1 gelöst. Bevorzugte Ausführungen gehen aus den Unteransprüchen hervor.

Ein erfindungsgemäßes Verfahren zur Herstellung der Anordnung geht aus weiteren Ansprüchen hervor.

Die vorliegende Erfindung umfasst eine Anordnung zum Anschluss eines Flächenkörpers an eine Spannungsversorgung, mit einem Flachbandkabel, einer Steuereinheit und einem Anschlusselement. Die Spannungsversorgung ist zumindest zur Versorgung der Steuereinheit mit einer elektrischen Spannung vorgesehen. Der Flächenkörper weist eine elektrisch leitfähige Struktur und eine Schaltfläche zur Generierung eines Steuersignals auf. Die Steuereinheit ist zum Empfang des Steuersignals vorgesehen, und ist zwischen dem Flächenkörper und dem Anschlusselement in einem Isolationsmaterial eingebettet.

Derartige Anordnungen weisen eine verkürzte Verkabelung zwischen kapazitiv sensitiven Flächenkörper und Spannungsversorgung auf, so dass die Schaltfläche gut vor parasitären Kapazitäten der Verkabelung geschützt ist.

Der Flächenkörper kann Materialien wie Glas oder Kunststoff enthalten und als Einscheibenglas oder als Verbundscheibe mit zwei durch eine thermoplastische Klebefolie fest miteinander verbundenen Einzelscheiben ausgebildet sein. Beispielhaft kann der Flächenkörper eine Verbundscheibe mit einer elektrischen Heizeinrichtung oder einem Antennenleiter sein.

Die elektrisch leitfähige Struktur des Flächenkörpers ist über das Flachbandkabel und das Anschlusselement mit einer Spannungsversorgung elektrisch verbindbar. Unter einem "Flachbandkabel" wird erfindungsgemäß ein ein- oder mehradriges Kabel verstanden. Das Flachbandkabel weist mehrere Flachbandleiter auf, die durch eine Ummantelung aus Isolationsmaterial (z.B. Polyamid oder Kapton) entlang des Flachbandkabels parallel auf Abstand zueinander gehalten werden. Ein Flachbandleiter kann beispielhaft ein band- bzw. streifenförmiger Leiter aus Metallfolie mit einer sehr geringen Schichtdicke im ein- oder zweistelligen Mikrometerbereich sein.

Über die Schaltfläche des Flächenkörpers kann eine Funktionalität des Flächenkörpers per Berührung der Schaltfläche gesteuert werden. Solche Schaltflächen können als Linien- oder eine Flächenelektrode oder durch zwei gekoppelte Elektroden als kapazitive Schaltflächen ausgebildet sein und nach der sogenannten Touch Control-Technologie arbeiten. Beispielsweise wird die elektrische Heizeinrichtung des Flächenkörpers über diese Schaltfläche gesteuert.

Nähert sich ein Objekt, vorzugsweise ein menschlicher Finger, der Schaltfläche, so ändert sich aufgrund der elektrischen Ladungen des Objekts die Kapazität der Elektroden. Die Kapazitätsänderung bewirkt einen Ladungstransport, so dass ein elektrischer Strom fließt und dadurch ein Steuersignal der Steuereinheit generiert werden kann. Das Steuersignal kann ein Schaltsignal zum Ein- oder Ausschalten der Heizeinrichtung sein.

Die Steuereinheit ist zum Empfang des Steuersignals vorgesehen. Bei der Steuereinheit handelt es sich vorzugsweise um einen Mikrochip (IC), der auf einer Elektronikplatine (PCB) angeordnet sein kann. Solche Elektronikplatinen können weitere elektronische Bauteile aufweisen. Die Steuereinheit umfasst bevorzugt eine Sensorelektronik, insbesondere eine kapazitive Sensorelektronik zur Steuerung der Funktionalität des Flächenkörpers.

Eine Sensitivität der Sensorelektronik wird derart eingestellt, dass die Sensorelektronik bei einer Berührung des Schaltbereichs mit einem menschlichen oder mehreren Fingern ein Steuersignal ausgibt. Unter einer Berührung des Schaltbereichs kann auch jede andere Art von Wechselwirkung mit dem Schaltbereich verstanden werden, die eine Änderung der Kapazität erzeugt. Vorzugsweise wird das Steuersignal nur bei der Berührung einer Substratseite des Flächenkörpers ausgelöst.

Die Steuereinheit ist zwischen dem Flächenkörper und dem Anschlusselement in einem Isolationsmaterial eingebettet. Derartige Anordnungen weisen eine räumliche Nähe von Steuereinheit und Flächenkörper und somit eine verkürzte, feste Länge des Flachbandkabels auf. Dadurch können vorteilhaft die parasitären Kapazitäten von der Schaltfläche entkoppelt und Verluste reduziert werden. Die Einstellung der Sensitivität der Schaltfläche wird somit vereinfacht.

Vorteilhafterweise kann eine nachträgliche Anpassung der Sensitivität der Schaltfläche aufgrund von Leitungslängenschwankungen bei geringen Verlusten entfallen.

Erfindungsgemäß weist die Anordnung ein Gehäuse mit einer Leitungsverbindung zwischen einem elektrischen Leiter und einem im Flachbandkabel verlaufenden Flachbandleiter auf, wobei die Steuereinheit im Gehäuse angeordnet ist. Eine weitere Verbesserung der Anordnung zeigt sich darin, dass die Steuereinheit eine stabile Verbindung mit dem Flächenkörper bildet. Derartige Gehäuse bestehen aus Kunststoff, beispielsweise Polyimid, und umfassen im Innern ein Polymermaterial aufweisendes Isolationsmaterial. Das Isolationsmaterial weist Eigenschaften auf, die die Steuereinheit luft- und wasserdicht gegenüber der äußeren Umgebung abschirmen.

Erfindungsgemäß umfasst das Gehäuse ein Einstellungsmittel zur Anpassung einer Sensitivität der Steuereinheit. Derartige Einstellungsmittel sind zu einer Änderung einer internen Vergleichskapazität der Steuereinheit vorgesehen. Ein Grund für eine Änderung der Vergleichskapazität kann eine veränderte Ausgestaltung der Elektroden in der Schaltfläche sein.

Beispielsweise handelt es sich bei dem Einstellungsmittel um ein Verbindungselement, z.B. eine Schraube, deren Schraubenkopf gut zugänglich von außerhalb des Gehäuses angeordnet sein kann. Alternativ zur Schraube kann das Einstellungsmittel als ein zusätzlicher parallel verlaufender Flachbandleiter oder Anschluss (Terminal) auf dem Gehäuse sein.

Bei einer weiteren vorteilhaften Ausgestaltung der Erfindung kann das Anschlusselement zur Vernetzung des Flächenkörpers in einem Fahrzeug oder Gerät vorgesehen sein. Das Anschlusselement kann somit eine serielle Schnittschnelle eines Bussystems, beispielsweise eines CAN-Bussystems, des Fahrzeugs sein.

Bei einer weiteren vorteilhaften Ausgestaltung der erfindungsgemäßen Anordnung wird die Steuereinheit zumindest teilweise im Flachbandkabel angeordnet. Insbesondere wird die Steuereinheit im Isolationsmaterial des Flachbandkabels eingebettet. Dabei ist die Steuereinheit zumindest mit einem Flachbandleiter direkt elektrisch kontaktiert.

Das Isolationsmaterial des Flachbandkabels kann aus Kunststoff, z.B. Polyimid, bestehen. Durch eine derartige Anordnung konnte die Anzahl von speziellen (OEM spezifischen) Anschlusselementen, die spezifisch zu einer Einbauumgebung des Flächenkörpers passen müssen, auf ein Anschlusselement reduziert werden.

Vorteilhafterweise weist die Steuereinheit ein Einstellungsmittel zur Anpassung einer Sensitivität der Steuereinheit auf. Das Einstellungsmittel kann ein Kondensator sein, dessen Kapazität zur geometrischen Ausgestaltung des Flachbandleiters und der elektrisch leitfähigen Struktur angepasst werden kann.

Außerdem betrifft die Erfindung einen Flächenkörper gemäß Anspruch 8.

Ein derartiger Flächenkörper beansprucht einen sehr geringen Platzverbrauch in der Lagerung, beim Transport des Flächenkörpers und im eigebauten Zustand eines Fahrzeugs oder Geräts.

Die Erfindung betrifft auch ein Verfahren zur Herstellung einer Anordnung gemäß Anspruch 9.

Bei einer vorteilhaften Ausgestaltung des Verfahrens wird ein elektrischer Leiter mit einem im Flachbandkabel verlaufenden Flachbandleiter elektrisch leitend verbunden. Die Verbindung zwischen dem Leiter und dem Flachbandleiter sowie die Steuereinheit werden in einem Gehäuse angeordnet und fixiert. Das Gehäuse wird mit dem Isolationsmaterial vergossen. Alternativ kann vor dem Vergießen mit Isolationsmaterial ein Schutzlack auf die Steuereinheit aufgebracht werden.

Vorteilhafterweise wird das Gehäuse aus zwei Halbschalen gebildet. Eine erste mit dem Isolationsmaterial gefüllte Halbschale ist zur Aufnahme des mit dem Flachbandleiter verbundenen Leiters und der Steuereinheit vorgesehen. In einem weiteren Verfahrensschritt wird eine zweite Halbschale auf die erste Halbschale aufgesetzt, so dass ein kastenförmiges Gehäuse durch die erste und zweite Halbschale gebildet wird.

Denkbar ist auch, dass die Verbindung zwischen Leiter und Flachbandleiter sowie die Steuereinheit in einem ersten Verfahrensschritt von dem Isolationsmaterial umhüllt werden und in einem zweiten Verfahrensschritt durch ein kapselndes, einstückig geformtes Gehäuse im Innern des Gehäuses aufgenommen werden.

Bei einer weiteren vorteilhaften Ausgestaltung des Verfahrens wird die Steuereinheit im Isolationsmaterial des Flachbandkabels zumindest teilweise eingebettet. Es ist bevorzugt, dass die Steuereinheit mittels Laminierung in das Isolationsmaterial des Flachbandkabels eingebettet wird.

Zusätzlich kann die Steuereinheit durch eine weitere Schicht umhüllt werden. Diese Schicht ist vorzugsweise eine flexible, aus einem elektrisch leitfähigen Material bestehende Folie, die vorteilhaft die Steuereinheit vor Beschädigung schützt. Weiterhin kann die Folie die Steuereinheit zumindest teilweise umhüllen und vorteilhaft die Elektromagnetische Verträglichkeit (EMV) der Anordnung beeinflussen.

Im Folgenden soll die Erfindung anhand von Figuren und Ausführungsbeispielen näher erläutert werden. Dabei zeigen:
- Fig. 1: eine schematische Ansicht einer ersten Ausführungsform einer Anordnung zum Anschluss eines Flächenkörpers
- Fig. 2: eine schematische Ansicht einer zweiten Ausführungsform einer Anordnung zum Anschluss eines Flächenkörpers
- Fig. 3: ein Querschnitt eines Flachbandkabel mit eingebetteter Steuereinheit
- Fig. 4: ein Flussdiagramm eines beispielhaften Verfahrens zur Herstellung einer erfindungsmäßigen Anordnung, bei welchem eine Steuereinheit in ein Isolationsmaterial eines Flachbandkabels eingebettet wird.

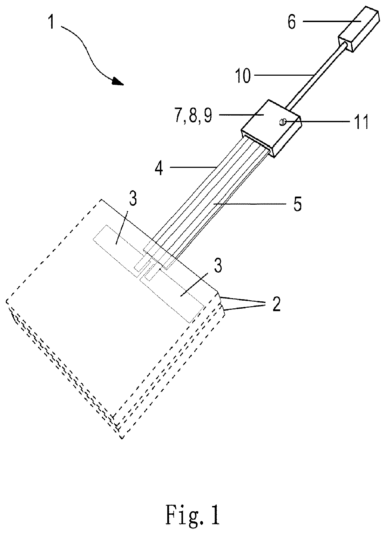

Figur 1 zeigt eine erste Ausführungsform einer Anordnung 1 zum Anschluss eines Flächenkörpers an eine Spannungsversorgung. Bei dem Flächenkörper handelt es sich um eine Verbundscheibe 2, die aus zwei Einzelscheiben gebildet wird. Die Einzelscheiben werden durch eine thermoplastische Klebefolie fest miteinander verbunden. Die Einzelscheiben bestehen vorzugsweise aus Glas, alternativ können die Einzelscheiben aus nicht-gläsernem Material, beispielsweise aus Kunststoff, gefertigt werden.

Die Verbundscheibe 2 weist eine elektrische Heizeinrichtung oder eine andere Funktionalität der Verbundscheibe 2 auf, die über eine elektrisch leitfähige Struktur mit einer entsprechenden Spannungsversorgung zum Betreiben der Verbundscheibe 2 gespeist wird. Die elektrisch leitfähige Struktur ist in Form von mehreren Sammelleitern in der Verbundscheibe 2 integriert.

Weiterhin weist die Verbundscheibe 2 eine in der Verbundscheibe integrierte Schaltfläche auf, welche aus derselben leitfähigen Struktur wie der der Heizfunktion gebildet sein kann über die beispielsweise die Heizeinrichtung gesteuert werden kann.

Die Schalfläche und die Heizeinrichtung sind sowohl voneinander elektrisch als auch optisch auf der Verbundscheibe getrennt. Die Schaltfläche kann mit einer für Fahrzeuge üblichen Spannungsversorgung von z.B. 12V oder 48V (Bordnetz) betrieben werden, wobei die Heizeinrichtung mit einer entsprechenden Heizspannung versorgt werden sollte.

Solche Schaltflächen können als Linien- oder eine Flächenelektrode oder durch zwei gekoppelte Elektroden als kapazitive Schaltflächen ausgebildet sein und nach der sogenannten Touch Control-Technologie arbeiten. Die Schaltfläche befindet sich vorzugsweise am äußeren Rand der Verbundscheibe 2, unweit zu einem der Sammelleiter und liegt bei einer Heizanwendung vorzugsweise längst der Stromrichtung, um die Homogenität einer Heizschicht nicht zu beeinflussen.

Nähert sich ein Objekt, vorzugsweise ein menschlicher Finger oder ein Element mit ähnlichen Permittivitätseigenschaften, der Schaltfläche, so ändert sich aufgrund der elektrischen Ladungen des Objekts die Kapazität der Elektroden. Die Kapazitätsänderung bewirkt einen Ladungstransport. Ein elektrischer Strom fließt und generiert ein Steuersignal. Das Steuersignal ist ein Schaltsignal, dass beispielsweise das Ein- oder Ausschalten der Heizeinrichtung, steuern kann.

Das Steuersignal wird über eine elektrische Leitungsverbindung 3 an eine Steuereinheit 7 weitergeleitet. Hierzu ist die Schaltfläche mit einem Flachbandleiter 5 eines zweiadrigen Flachbandkabels 4 elektrisch leitend verbunden. Unter einem Flachbandleiter 5, auch Folienleiter oder Flachleiter genannt, wird ein elektrischer Leiter verstanden, dessen Breite deutlich größer ist als seine Dicke. Der Flachbandleiter 5 ist mit einem Isoliermaterial 8, beispielsweise einer Polyimidschicht, elektrisch isoliert und als Flachbandkabel 4 über den Rand der Verbundscheibe 2 nach außen geführt.

Das Flachbandkabel 4 mündet in einem Gehäuse 9, in dem der Flachbandleiter 5 mit einem Leiter, beispielsweise einem Rundleiter 10, elektrisch verbunden wird. Im Gehäuse 9 ist auch die Steuereinheit 7 angeordnet und elektrisch mit dem Flachbandleiter 5 oder Rundleiter 10 kontaktiert, so dass die Steuereinheit 7 das an der Schaltfläche generierte Steuersignal empfangen und auswerten kann. Das Gehäuse 9 ist zumindest teilweise mit einem Isolationsmaterial gefüllt, in das die Steuereinheit 7 eingebettet ist.

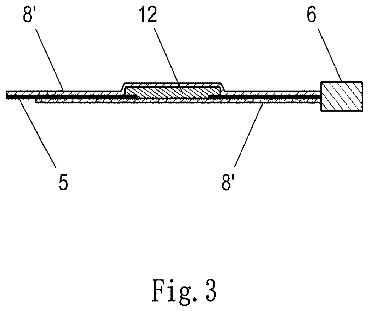

Bei der Steuereinheit 7 handelt es sich vorzugsweise um eine kapazitive Sensorelektronik zur Steuerung der Touch Control Technologie. Die Sensorelektronik kann Mikrochip sein, der auf einer Elektronikplatine (PCB) 12 wie in Figur 3 dargestellt, angeordnet ist. Solche Elektronikplatinen können auch weitere elektronische Bauteile aufweisen.

Das Gehäuse 9 weist eine Schraube 11 oder jedes andere Verbindungselement auf, die als ein Einstellungsmittel zur Anpassung einer Sensitivität der Steuereinheit 7 dient. Dabei ist ein Schraubenkopf der Schraube 11 der Schraube an der Gehäuseoberfläche von außen gut zugänglich. Auf diese Weise kann eine Anpassung der Sensitivität der Steuereinheit 7 auch bei geschlossenem Gehäuse vorgenommen werden.

Der Rundleiter 10 wird über eine Öffnung aus dem Gehäuse 9 hinaus geführt und ist an seinem zweiten Ende mit einem Anschlusselement 6 elektrisch verbunden.

Das Anschlusselement ist zur Kontaktierung der Verbundscheibe 2 in einer Fahrzeugelektronik vorgesehen. Das Anschlusselement ist fahrzeugspezifisch oder passend zu einem Bussystems des Fahrzeugs als Stecker ausgebildet. Beispielsweise kann das Anschlusselement eine serielle Schnittschnelle eines CAN-Bussystems des Fahrzeugs sein.

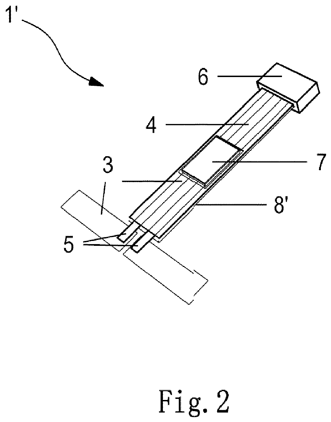

Figur 2 zeigt eine zweite Ausführungsform einer Anordnung 1' zum Anschluss eines Flächenkörpers. Analog zu der Ausführungsform in Figur 1 verfügt die Verbundscheibe 2 über eine elektrische Heizeinrichtung, die über den Sammelleitern mit der Spannungsversorgung elektrisch kontaktiert ist. Weiterhin weist die Verbundscheibe 2 eine integrierte Schaltfläche auf, über den die Heizeinrichtung oder eine beliebige andere Funktionalität gesteuert werden kann. Hierzu ist die Schaltfläche mit dem Flachbandleiter 5 elektrisch leitend verbunden.

Im Unterschied zum Ausführungsbeispiel der Figur 1 weist die Anordnung 1' in Figur 2 kein Gehäuse 9 auf, in dem die Steuereinheit 7 untergebracht werden könnte. Weiterhin ist die Steuereinheit 7 mit dem Flachbandleiter 5 elektrisch kontaktiert. Im zweiten Ausführungsbeispiel ist die Steuereinheit 7 im Isolationsmaterial 8 des Flachbandkabels 4 eingebettet.

Das Flachbandkabel 4 endet mit dem Anschlusselement 6, das wiederum als ein Stecker passend zu der Einbauumgebung eines Fahrzeugs ausgebildet ist.

Figur 3 zeigt einen Querschnitt des Flachbandkabels 4 aus Figur 2 mit eingebetteter Steuereinheit 7. Das Flachbandkabel 4 weist an seinem ersten Ende einen ummantelungsfreien Bereich des Flachbandleiters 5 auf. Dieser Bereich dient zur Kontaktierung des Flachbandleiters 5 mit eine Kontaktstelle der sensitiven Struktur der Verbundscheibe 2.

Der Flachbandleiter 5 ist in seinem weiteren Verlauf zwischen seinem ersten Ende, das mit der Leitungsverbindung 3 der Verbundscheibe 2 kontaktiert ist, und seinem zweiten Ende mit der im Isolationsmaterial 8 eingebetteten Steuereinheit 7 elektrisch kontaktiert. Das Flachbandkabel 4 endet an seinem zweiten Ende in dem Anschlusselement 6, das als Stecker zum Verbinden mit der Einbauumgebung des Fahrzeugt dient.

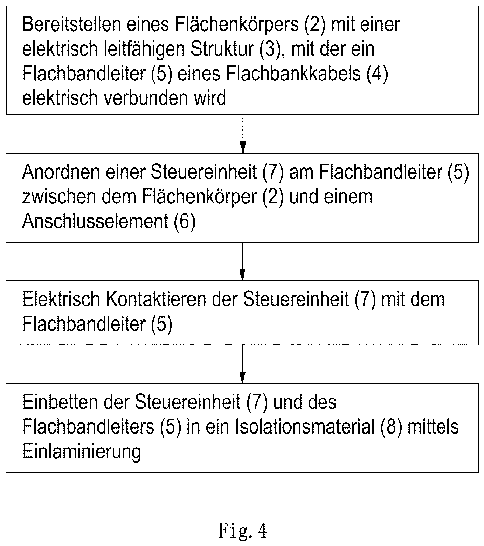

Figur 4 zeigt ein Flussdiagramm eines beispielhaften Verfahrens zur Herstellung einer erfindungsmäßigen Anordnung 1', bei dem in einem ersten Schritt ein Flächenkörper 2 mit einer elektrisch leitfähigen Struktur 3 bereitgestellt und mit der ein Flachbandleiter 5 eines Flachbandkabels 4 elektrisch verbunden wird.

Im zweiten Schritt wird eine Steuereinheit 7 am Flachbandleiter 5 zwischen dem Flächenkörper 2 und dem Anschlusselement 6 angeordnet. In einem dritten Schritt wird die Steuereinheit 7 mit dem Flachbandleiter 5 kontaktiert. In einem weiteren Schritt werden die Steuereinheit 7 und der Flachbandleiters 5 im Isolationsmaterial 8' eingebettet. Dabei wird die Steuereinheit 7 mittels Laminierung in dem Isolationsmaterial des Flachbandkabels untergebracht.

Zusätzlich kann die Steuereinheit 7 durch eine weitere Schicht umhüllt werden. Die Schicht ist vorzugsweise eine flexible, aus einem elektrisch leitfähigen Material bestehende Folie.

### Bezugszeichenliste:

- 1: eine erste Ausführungsform einer Anordnung
- 1': eine zweite Ausführungsform der Anordnung
- 2: Verbundscheibe
- 3: Leitungsverbindung
- 4: Flachbandkabel
- 5: Flachbandleiter
- 6: Anschlusselement
- 7: Steuereinheit
- 8: Isolationsmaterial
- 8': Isolationsmaterial des Flachbandkabels
- 9: Gehäuse
- 10: elektrischer Rundleiter
- 11: Schraube
- 12: Elektronikplatine

## Patentansprüche

1. Anordnung (1, 1') zum Anschluss eines Flächenkörpers (2) an eine Spannungsversorgung, mit einem Flachbandkabel (4), einer Steuereinheit (7) und einem Anschlusselement (6), wobei die Spannungsversorgung zumindest zur Versorgung der Steuereinheit (7) mit einer elektrischen Spannung vorgesehen ist und der Flächenkörper (2)
- eine elektrisch leitfähige Struktur (3),
- eine kapazitive Schaltfläche zur Generierung eines Steuersignals aufweist und die Steuereinheit (7) zum Empfang des Steuersignals vorgesehen ist,
- wobei die Anordnung ein Gehäuse (9) mit einer Leitungsverbindung zwischen einem elektrischen Leiter (10) und einem im Flachbandkabel (4) verlaufenden Flachbandleiter (5) aufweist,
- wobei die Steuereinheit (7) im Gehäuse (9) angeordnet ist,
**dadurch gekennzeichnet, dass** die Steuereinheit (7) zwischen dem Flächenkörper (2) und dem Anschlusselement (6) in einem Isolationsmaterial (8, 8') eingebettet ist, und dass
das Gehäuse (9) ein Einstellungsmittel (11) zur Anpassung einer Sensitivität der Steuereinheit (7) aufweist.

2. Anordnung (1) nach Anspruch 1, wobei das Anschlusselement (6) zur Vernetzung des Flächenkörpers (2) in einem Fahrzeug vorgesehen ist.

3. Anordnung (1) nach Anspruch 2, wobei das Anschlusselement (6) eine serielle Schnittstelle eines Bussystems des Fahrzeugs ist.

4. Anordnung (1') nach Anspruch 1, wobei die Steuereinheit (7) zumindest teilweise im Flachbandkabel (4) angeordnet ist.

5. Anordnung (1') nach Anspruch 4, wobei die Steuereinheit (7) zumindest teilweise im Isolationsmaterial (8') des Flachbandkabels (4) eingebettet ist.

6. Anordnung (1') nach Anspruch 4, wobei die Steuereinheit (7) ein Einstellungsmittel, insbesondere einen Kondensator, zur Anpassung einer Sensitivität der Steuereinheit (7) aufweist.

7. Anordnung (1') nach Anspruch 1, wobei die Steuereinheit (7) eine Elektronikplatine mit zumindest einem elektronischen Bauelement und einer Verbindungsschnittstelle aufweist.

8. Flächenkörper (2) mit einer Anordnung nach einem der Ansprüche 1 bis 7 zum Anschluss des Flächenkörpers an eine Spannungsversorgung eines Fahrzeugs, die zumindest zur Versorgung der Steuereinheit (7) mit einer elektrischen Spannung vorgesehen ist.

9. Verfahren zur Herstellung einer Anordnung nach Anspruch 1, bei welchem die Steuereinheit (7) zwischen dem Flächenkörper (2) und dem Anschlusselement (6) in einem Isolationsmaterial (8) eingebettet wird.

10. Verfahren nach Anspruch 9, bei welchem
- ein elektrischer Leiter (10) mit einem im Flachbandkabel (4) verlaufenden Flachbandleiter (5) elektrisch leitend verbunden wird,
- die Verbindung zwischen dem Leiter (10) und dem Flachbandleiter (5) sowie die Steuereinheit (7) in einem Gehäuse (9) angeordnet und fixiert werden und
- das Gehäuse (9) mit dem Isolationsmaterial vergossen wird.

11. Verfahren nach Anspruch 9, bei welchem die Steuereinheit (7) im Isolationsmaterial (8') des Flachbandkabels (4) zumindest teilweise eingebettet wird.

12. Verfahren nach Anspruch 11, wobei die Steuereinheit (7) mittels Laminierung in das Isolationsmaterial (8') des Flachbandkabels (4) eingebettet wird.

## Claims

1. Assembly (1, 1') for connecting a flat body (2) to a voltage supply, having a ribbon cable (4), a control unit (7), and a connection element (6), wherein the voltage supply is provided at least to supply the control unit (7) with an electric voltage and the flat body (2) has
- an electrically conductive structure (3) ,
- a capacitive switching surface for generating a control signal, and
the control unit (7) is provided to receive the control signal,
- wherein the assembly has a housing (9) with a line connection between an electrical conductor (10) and a flat strip conductor (5) running in the ribbon cable (4)
- wherein the control unit (7) is arranged in the housing (9),
**characterized in that** the control unit (7) is embedded in an insulating material (8, 8') between the flat body (2) and the connection element (6)
and that the housing (9) has a setting means (11) for adjusting a sensitivity of the control unit (7).

2. Assembly (1) according to claim 1, wherein the connection element (6) is provided to network the flat body (2) in a vehicle.

3. Assembly (1) according to claim 2, wherein the connection element (6) is a serial interface of a bus system of the vehicle.

4. Assembly (1') according to claim 1, wherein the control unit (7) is arranged at least partially in the ribbon cable (4).

5. Assembly (1') according to claim 4, wherein the control unit (7) is embedded at least partially in the insulating material (8') of the ribbon cable (4).

6. Assembly (1') according to claim 4, wherein the control unit (7) has a setting means, in particular a capacitor, for adjusting a sensitivity of the control unit (7).

7. Assembly (1') according to claim 1, wherein the control unit (7) has an electronic board with at least one electronic component and a connecting interface.

8. Flat body (2) with an assembly according to one of claims 1 through 7 for connecting the flat body to a voltage supply of a vehicle, which is provided at least to supply the control unit (7) with an electric voltage.

9. Method for producing an assembly according to claim 1, wherein the control unit (7) is embedded in an insulating material (8) between the flat body (2) and the connection element (6).

10. Method according to claim 9, wherein
- an electrical conductor (10) is electrically conductingly connected to a flat strip conductor (5) running in the ribbon cable (4),
- the connection between the conductor (10) and the flat strip conductor (5) and the control unit (7) are arranged and secured in a housing (9), and
- the housing (9) is cast with the insulating material.

11. Method according to claim 9, wherein the control unit (7) is at least partially embedded in the insulating material (8') of the ribbon cable (4).

12. Method according to claim 11, wherein the control unit (7) is embedded in the insulating material (8') of the ribbon cable (4) by lamination.

## Revendications

1. - Système (1, 1') pour le raccordement d'un corps plat (2) à une alimentation en tension, comportant un câble-ruban plat (4), une unité de commande (7) et un élément de raccordement (6), l'alimentation en tension étant prévue au moins pour l'alimentation de l'unité de commande (7) par une tension électrique, et le corps plat (2) présentant :
- une structure (3) conductrice de l'électricité ;
- une surface de commutation capacitive pour la génération d'un signal de commande, et l'unité de commande (7) est prévue pour la réception du signal de commande ;
- le système présentant un boîtier (9) avec une connexion filaire entre un conducteur électrique (10) et un conducteur-ruban plat (5) s'étendant dans le câble-ruban plat (4) ;
- l'unité de commande (7) étant disposée dans le boîtier (9),
**caractérisé par le fait que** l'unité de commande (7) est intégrée dans un matériau d'isolation (8, 8') entre le corps plat (2) et l'élément de raccordement (6), et **par le fait que** le boîtier (9) présente un moyen de réglage (11) pour l'adaptation d'une sensibilité de l'unité de commande (7).

2. - Système (1) selon la revendication 1, dans lequel l'élément de raccordement (6) est prévu pour la mise en réseau du corps plat (2) dans un véhicule.

3. - Système (1) selon la revendication 2, dans lequel l'élément de raccordement (6) est une interface série d'un système de bus du véhicule.

4. - Système (1') selon la revendication 1, dans lequel l'unité de commande (7) est disposée au moins partiellement dans le câble-ruban plat (4).

5. - Système (1') selon la revendication 4, dans lequel l'unité de commande (7) est au moins partiellement intégrée dans le matériau d'isolation (8') du câble-ruban plat (4).

6. - Système (1') selon la revendication 4, dans lequel l'unité de commande (7) présente un moyen de réglage, en particulier un condensateur, pour l'adaptation d'une sensibilité de l'unité de commande (7).

7. - Système (1') selon la revendication 1, dans lequel l'unité de commande (7) présente une carte électronique avec au moins un composant électronique et une interface de connexion.

8. - Corps plat (2) avec un système selon l'une des revendications 1 à 7 pour le raccordement du corps plat à une alimentation en tension d'un véhicule, qui est prévue au moins pour l'alimentation de l'unité de commande (7) par une tension électrique.

9. - Procédé de fabrication d'un système selon la revendication 1, dans lequel l'unité de commande (7) est intégrée dans un matériau d'isolation (8) entre le corps plat (2) et l'élément de raccordement (6).

10. - Procédé selon la revendication 9, dans lequel :
- un conducteur électrique (10) est relié de manière conductrice de l'électricité à un conducteur-ruban plat (5) s'étendant dans le câble-ruban plat (4) ;
- la connexion entre le conducteur (10) et le conducteur-ruban plat (5) ainsi que l'unité de commande (7) sont disposées et fixées dans un boîtier (9) ; et
- le boîtier (9) est scellé par le matériau d'isolation.

11. - Procédé selon la revendication 9, dans lequel l'unité de commande (7) est au moins partiellement intégrée dans le matériau d'isolation (8') du câble-ruban plat (4).

12. - Procédé selon la revendication 11, dans lequel l'unité de commande (7) est intégrée par stratification dans le matériau d'isolation (8') du câble-ruban plat (4).
